# EUROPÄISCHE PATENTSCHRIFT

(11) **EP 0 785 708 B1**
(45) Veröffentlichungstag und Bekanntmachung des Hinweises auf die Patenterteilung: **23.06.1999**
(21) Anmeldenummer: 97100300.9
(22) Anmeldetag: 10.01.1997
(51) Int. Cl.: H05K 9/00, H01T 4/08

(54) **Anordnung zum Schutz elektrischer und elektronischer Bauelmente vor elektrostatischen Entladungen**
Electrostatic discharge protection device for electrical and electronic components
Dispositif de protection de composants électriques et électroniques contre les décharges électrostatiques

(30) Priorität: 18.01.1996 DE 19601650
(43) Veröffentlichungstag der Anmeldung: 23.07.1997
(73) Patentinhaber: TEMIC TELEFUNKEN microelectronic GmbH, 74072 Heilbronn (DE)
(72) Erfinder: Schuster, Alfred, 85098 Grossmehring (DE)
(74) Vertreter: Maute, Hans-Jürgen, Dipl.-Ing.

(56) Entgegenhaltungen:
- DE-U- 29 520 176
- US-A- 3 725 745
- US-A- 4 586 105
- US-A- 4 725 923

## Beschreibung

Die Erfindung betrifft eine Anordnung zum Schutz elektrischer und elektronischer Bauelemente vor elektrostatischen Entladungen (ESD: electrostatic discharge) gemäß dem oberbegriff des Patentanspruchs 1.

Insbesondere in der Automobilindustrie werden an elektrische und elektronische Baugruppen hinsichtlich der Widerstandsfähigkeit gegenüber elektrostatischen Entladungen hohe Anforderungen gestellt. Eine solche Baugruppe soll demgemäß über Schutzeinrichtungen verfügen, die eine meist von außen aufgebrachte elektrostatische Entladung ableiten oder anderweitig unschädlich machen, um empfindliche Bauelemente gegen Zerstörung durch elektrostatische Entladungen zu schützen.

Als wesentlicher und kritischer Zugang für ESD-Pulse in elektrische oder elektronische Baugruppen sind der oder die Baugruppenstecker anzusehen, da auf diesem Wege ESD-Pulse direkt auf die Schaltung geleitet werden. Die Gehäuse der Baugruppen hingegen stellen hinsichtlich des ESD-Schutzes in der Regel kein Problem dar. Sie bestehen häufig aus Kunststoff bzw. Metall, so daß eine per ESD zugeführte, elektrische Ladung nicht auf die Schaltung weitergeleitet bzw. auf unschädliche Art und Weise abgeleitet wird.

Nach dem Stand der Technik werden zum ESD-Schutz hauptsächlich sog. Abblockkondensatoren eingesetzt, die die elektrische Ladung aufnehmen und dadurch die Spannung auf der betreffenden Leitung auf einen unkritischen Wert begrenzen. Nachteilig ist hierbei, daß pro verwendetem Steckerpin ein Kondensator ausschließlich zum ESD-Schutz vorgesehen werden muß, wodurch Kosten entstehen und Platz auf der Leiterplatte beansprucht wird.

Weiterhin ist aus der US-Patentschrift 3,725,745 eine Anordnung zum Schutz elektrischer und elektronischer Bauelemente vor elektrostatischen Entladungen bekannt, bei der ein Leiter über eine Isolationsschicht fest mit einer Metallplatte verbunden ist. Die isolationsschicht weist eine Öffnung auf, über die der Leiter zur Bildung einer Funkenstrecke zwischen Leiter und der Metallplatte geführt wird und in der zudem ein Strombegrenzer angeordnet ist.

Es ist Aufgabe der Erfindung, eine alternative Anordnung zum Schutz vor elektrostatischen Entladungen anzugeben.

Diese Aufgabe wird gelöst durch eine Anordnung zum Schutz elektrischer und elektronischer Bauelemente vor elektrostatischen Entladungen, bei der eine die Bauelemente tragende Leiterplatte über eine Isolationsschicht mit einer Metallplatte verpreßt ist. Kennzeichnend ist, daß die Isolationsschicht wenigstens eine Öffnung aufweist und daß über diese Öffnung wenigstens eine Leitbahn zur Bildung einer ersten Funkenstrecke zwischen Leitbahn und Metallplatte geführt wird.

Die Vorteile der Erfindung liegen insbesondere darin, daß außer der Einsparung von Platz auf der Leiterplatte und Materialkosten für Kondensatoren der ESD-Schutz an einer beliebigen Stelle der Leiterplatte angebracht werden kann. Durch die Verwendung der Luft als leitendes Medium können weiterhin beliebig viele Entladungen auftreten, ohne daß z.B. der bei Kunststoffen gefürchtete Effekt der Karbonisierung auftritt, durch den das betreffende Material zumindest hochohmig leitend wird. Zudem fallen durch das Einbringen von Schlitzen in die Isolationsschicht keine zusätzlichen Kosten an.

In den Unteransprüchen sind vorteilhafte Ausführungsformen und Weiterbildungen der Erfindung beschrieben, beispielsweise die Bildung einer zweiten Funkenstrecke zwischen dem Metallstift und einem festen Potential.

Ausführungsbeispiele der Erfindung sind nachstehend ausführlich erläutert und anhand der Figuren dargestellt.

Es zeigen
- Fig. 1:: eine erste Ausführungsform des erfindungsgemäßen ESD-Schutzes,
- Fig. 2:: eine Variante der Ausführungsform nach Fig. 1,
- Fig. 3:: eine Detailansicht der Ausführungsformen nach Fig. 1, 2 und 4 und
- Fig. 4:: eine weitere Variante der Ausführungsform nach Fig. 1.

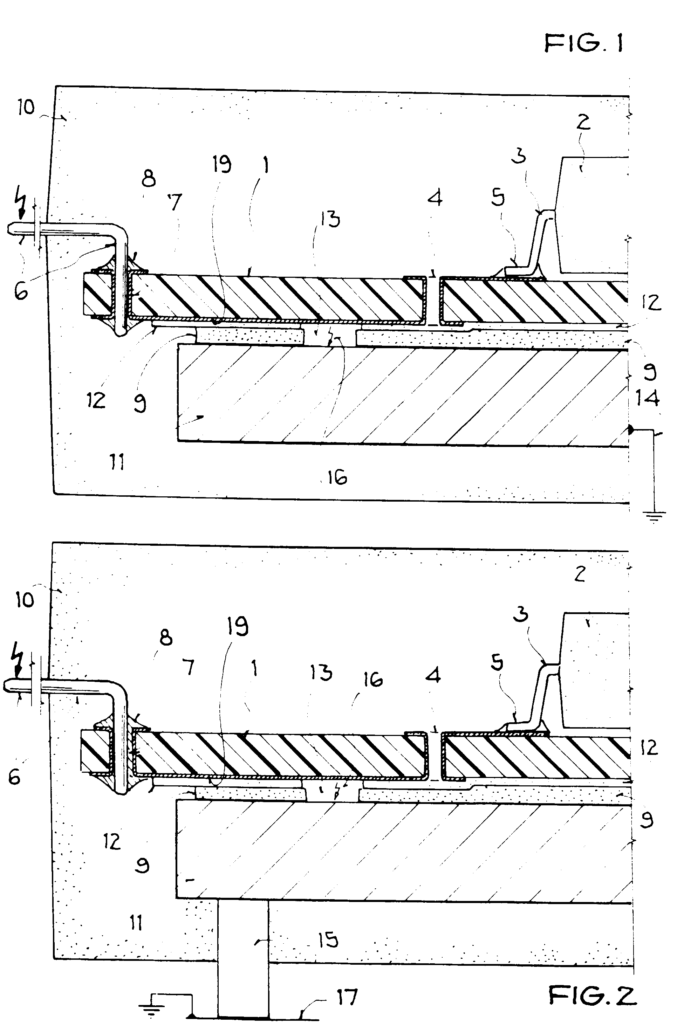

Die **Fig. 1, 2 und 4** zeigen in einem meist aus Kunststoff bestehenden Gehäuse **10** eine einseitig bestückte Leiterplatte **1**, auf deren Oberseite eine Schaltunganordnung aus elektrischen und elektronischen Bauelemente **2** mit Anschlüssen **3** und auf deren Unterseite ausschließlich Leitbahnen **19** angeordnet sind. Ferner sind Lötstellen **5** zur Verbindung der Anschlüsse **3** mit den Leitbahnen **19** und Durchkontaktierungen **4** vorhanden, mittels denen die Leitbahnen **19** auf der Ober- und Unterseite der Leiterplatte **1** miteinander verbunden sind. Für Steckerpins **6** zur Bildung einer Steckerverbindung sind in die Leiterplatte **1** Löcher **7** eingebracht, so daß die Steckerpins **6** eingesteckt und mittels eines Lotes **8** mechanisch mit der Leiterplatte **1** und elektrisch mit den Leitbahnen **19** verbunden werden können. Rückseitig ist die Leiterplatte **1** mit einer Lötstoplackschicht **12** und einer Isolationsschicht **9** versehen und auf eine vorteilhaft aus Aluminium bestehende Metallplatte **11** gepreßt. Beim Verpreßvorgang unter erhöhter Temperatur verklebt die Metallplatte **11** mit der Leiterplatte **1**, wobei die Isolationsschicht **9** gleichzeitig als Klebstoff wirkt. Die Isolationsschicht **9** weist eine geringe Dicke auf, um eine möglichst gute Wärmeleitfähigkeit zwischen Leiterplatte **1** und Metallplatte **11** zu gewährleisten.

Erfindungsgemäß weisen nun als ESD-Schutz die Isolationsschicht **9** und die Lötstoplackschicht **12** zwischen der Unterseite der Leiterplatte **1** und auflaminierter Metallplatte **11** eine schlitzförmige Öffnung **13** auf.

In der **Fig. 1** ist die Metallplatte **11** mittels einer elektrisch leitenden Verbindung **14** mit dem Bezugspotential verbunden; möglich ist auch die Verbindung mit der Versorgungsspannung der Schaltungsanordnung oder mit einem anderen festen Potential. Es ist wichtig, daß die zu schützende Leitbahn **19** auf der Unterseite der Leiterplatte **1** über dieser Öffnung **13** angeordnet ist.

Der erfindungsgemäßen Anordnung zum Schutz vor ESD-Pulsen liegt die Tatsache zugrunde, daß die Durchschlagsfestigkeit in Luft bei weitem niedriger ist als in festen, isolierenden Stoffen. Bei einer elektrostatischen Entladung auf den Steckerpin **6** erfolgt deshalb ein überschlag auf einer Funkenstrecke **16** innerhalb der Öffnung **13** von der Leitbahn **19** auf die Metallplatte **11**, so daß die Spannung auf dem Steckerpin **6** und der Leitbahn **19** auf beispielsweise 300 V begrenzt wird und so die Bauelemente **2** geschützt werden. Die Durchschlagspannung wird durch den Abstand zwischen Metallplatte **11** und der Leitbahn **19** und damit im wesentlichen durch die Dicke der Isolationsschicht **9** bestimmt.

Es ist zu beachten, daß die schlitzförmigen Öffnungen **13** weder zu schmal noch zu breit ausgelegt sind. Sind sie zu schmal, läuft beim Verpreßvorgang Harz als Bestandteil der Isolationsschicht **9** in die Öffnung **13** und verschließt diese und damit die Funkenstrecke **16** zwischen Metallplatte **11** und Leiterplatte **1**. Ist die Öffnung **13** zu breit, besteht die Gefahr, daß sich die Leiterplatte **1** beim Verpressen über der Öffnung **13** nach unten durchbiegt und ein Kurzschluß zwischen Leitbahn **19** und Metallplatte **11** ausgelöst wird.

Die wegen der Öffnung **13** freiliegenden Leitbahnen **19** sind von oben durch die Leiterplatte **1**, von unten durch die Metallplatte **11** und von allen Seiten durch die Isolationsschicht **9** hermetisch eingeschlossen und damit vor Umwelteinflüssen wie Feuchte und Verschmutzung geschützt.

In **Fig. 2** ist eine Lösung zum ESD-Schutz dargestellt, wenn bei denkbaren Anwendungsfällen die Metallplatte **11** nicht, wie in Fig. 1 gezeigt, direkt mit einem festen Potential verbunden werden kann. Hierzu ist beispielsweise in das Kunststoffgehäuse **10** ein Metallstift **15** eingespritzt, so daß nach dem Einbau entweder eine elektrisch leitende Verbindung oder wiederum eine Funkenstrecke zwischen dem Metallstift **15** und einer metallenen und auf Bezugspotential liegenden Fläche **17** z.B. der Karosserie eines Fahrzeugs, zustande kommt.

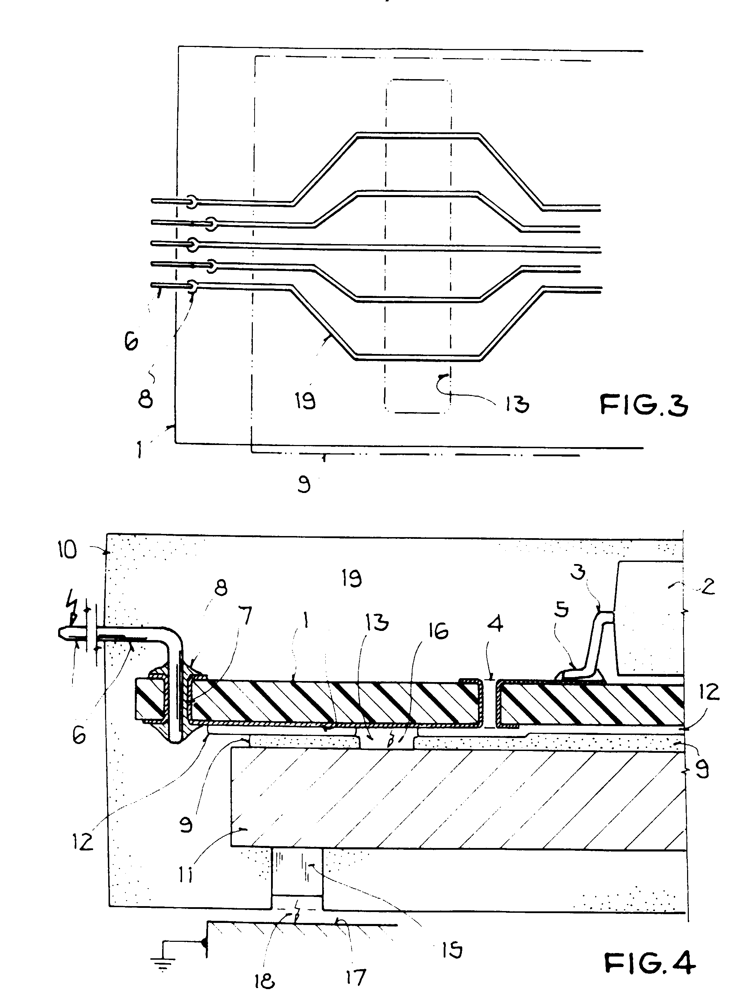

Die Detailansicht der **Fig. 3** zeigt, wie die zu schützenden Leitbahnen **19** im Bereich der Öffnung **13** vorzugsweise angeordnet sind. Um Oberflächenüberschläge und Kriechströme zu vermeiden, müssen die Leitbahnen **19** im Bereich der Öffnung **13** einen mindestens viermal größeren Abstand zueinander aufweisen als außerhalb der Öffnung **13**.

**Fig. 4** zeigt eine weitere Variante der Anordnung nach Fig. 1. Falls in besonderen Anwendungsfällen die Metallplatte **11** nicht direkt mit einem festen Potential, beispielsweise dem Bezugspotential, der Versorgungsspannung oder einem sonstigen festen Potential, verbunden werden kann, wird der Metallstift **15** mit einem bestimmten Abstand über einer Fläche **17**, bei der es sich um einen Teil des Gehäuses **10** oder der Karosserie eines Kraftfahrzeugs handeln kann und die auf einem festen Potential liegt, angeordnet, so daß eine zweite Funkenstrecke **18** entsteht. Diese zweite Funkenstrecke **18** stellt sicher, daß die Metallplatte **11** nicht galvanisch mit einem festen Potential verbunden ist und daß trotzdem elektrostatische Entladungen abgeleitet werden können.

Anwendbar ist die erfindungsgemäße Anordnung zum Schutz vor ESD-Pulsen insbesondere im Bereich der Planartechnologie, bei der eine Leiterplatte ein auflaminiertes Kühlblech aufweist.

## Patentansprüche

1. Anordnung zum Schutz elektrischer und elektronischer Bauelemente (2) vor elektrostatischen Entladungen, wobei eine die Bauelemente (2) tragende Leiterplatte (1) über eine Isolationsschicht (9) mit einer Metallplatte (11) fest verbunden ist, **dadurch gekennzeichnet**, daß die Verbindung zwischen Leiterplatte und Metallplatte durch Verpressen erzeugt ist und daß die Isolationsschicht (9) wenigstens eine Öffnung (13) aufweist und daß über diese Öffnung (13) wenigstens eine Leitbahn (19) zur Bildung einer ersten Funkenstrecke (16) zwischen Leitbahn (19) und Metallplatte (11) geführt wird.

2. Anordnung nach Anspruch 1, **dadurch gekennzeichnet**, daß die Metallplatte (**11**) direkt durch eine leitende verbindung (**14**) mit einem festen Potential verbunden ist.

3. Anordnung nach Anspruch 1, **dadurch gekennzeichnet**, daß die Leiterplatte (**1**) in einem Kunststoffgehäuse (**10**) angeordnet ist und die Metallplatte (**11**) einen in das Kunststoffgehäuse (**10**) eingespritzten Metallstift (**15**) kontaktiert.

4. Anordnung nach Anspruch 3, **dadurch gekennzeichnet**, daß der Metallstift (**11**) direkt mit einem festen Potential (**17**) verbunden ist.

5. Anordnung nach Anspruch 3, **dadurch gekennzeichnet,** daß zwischen dem Metallstift (**11**) und dem festen Potential (**17**) eine zweite Funkenstrecke (**18**) angeordnet ist.

6. Anordnung nach Anspruch 1, dadurch gekennzeichnet, daß die zu schützende Leitbahn (**19**) eine Zuführung zu einem Steckerpin (**6**) einer Steckerverbindung darstellt.

7. Anordnung nach Anspruch 1, **dadurch gekennzeichnet**, daß die Durchschlagspannung zwischen Leitbahn (**19**) und Metallplatte (**11**) durch die Dicke der Isolationsschicht (**9**) bestimmt wird.

8. Anordnung nach einem der Ansprüche 2, 4 oder 5, **dadurch gekennzeichnet**, daß es sich bei dem festen Potential um ein Bezugspotential handelt.

9. Anordnung nach einem der Ansprüche 2, 4 oder 5, **dadurch gekennzeichnet**, daß es sich bei dem festen Potential um eine Versorgungsspannung einer aus den Bauelementen (2) gebildeten Schaltungsanordnung handelt.

10. Anordnung nach einem der Ansprüche 2, 4 oder 5, **dadurch gekennzeichnet,** daß es sich bei dem festen Potential um ein beliebiges, festes Potential der Schaltungsanordnung handelt.

11. Anordnung nach Anspruch 1, **dadurch gekennzeichnet**, daß zwischen Leiterplatte (**1**) und Isolationsschicht (**9**) eine Lötstoplackschicht (**12**) angeordnet ist.

12. Anordnung nach Anspruch 1, **dadurch gekennzeichnet**, daß die Leitbahnen (19) über der Öffnung (13) einen mindestens viermal größeren Abstand zueinander aufweisen als außerhalb der Öffnung (13).

## Claims

1. Arrangement for protecting electrical and electronic components (2) against electrostatic discharge, in which a printed circuit board (1) bearing the components (2) is firmly connected to a metal plate (11) via an insulating layer (9), characterised in that the connection between the printed circuit board and the metal plate is produced by pressing, that the insulating layer (9) comprises at least one opening (13), and that at least one conductor track (19) is routed via this opening (13) to form a first spark gap (16) between the conductor track (19) and the metal plate (11).

2. Arrangement according to claim 1, characterised in that the metal plate (11) is directly connected to a fixed potential via a conductive connection (14).

3. Arrangement according to claim 1, characterised in that the printed circuit board (1) is arranged in a plastics casing (10) and the metal plate (11) contacts a metal pin (15) injected into the plastics casing (10).

4. Arrangement according to claim 3, characterised in that the metal pin (11) is directly connected to a fixed potential (17).

5. Arrangement according to claim 3, characterised in that a second spark gap (18) lies between the metal pin (11) and the fixed potential (17).

6. Arrangement according to claim 1, characterised in that the conductor track (19) to be protected represents a feed line to a plug pin (6) of a plug connection.

7. Arrangement according to claim 1, characterised in that the breakdown voltage between the conductor track (19) and the metal plate (11) is determined by the thickness of the insulating layer (9).

8. Arrangement according to any one of claims 2, 4 and 5, characterised in that the fixed potential is a reference potential.

9. Arrangement according to any one of claims 2, 4 and 5, characterised in that the fixed potential is a supply voltage of a circuit arrangement formed from the components (2).

10. Arrangement according to any one of claims 2, 4 and 5, characterised in that the fixed potential is an arbitrary, fixed potential of the circuit arrangement.

11. Arrangement according to claim 1, characterised in that a solder resist layer (12) is arranged between the printed circuit board (1) and the insulating layer (9).

12. Arrangement according to claim 1, characterised in that the distance between the conductor tracks (19) above the opening (13) is at least four times greater than that away from the opening (13).

## Revendications

1. Dispositif de protection de composants électriques et électroniques (2) contre des décharges électrostatiques, un circuit imprimé (1) portant les composants (2) étant réuni par l'intermédiaire d'une couche d'isolement (9) à une plaque métallique (11), caractérisé en ce que la liaison entre le circuit imprimé et la plaque métallique est réalisée par compression et en ce que la couche d'isolement (9) présente au moins une ouverture (13) et en ce qu'à travers cette ouverture (13) est guidée au moins une piste conductrice (19) en vue de la formation d'un trajet d'étincelle (16) entre la piste conductrice (19) et la plaque métallique (11).

2. Dispositif selon la revendication 1, caractérisé en ce que la plaque métallique (11) est portée directement à un potentiel fixe par l'intermédiaire d'une liaison conductrice (14).

3. Dispositif selon la revendication 1, caractérisé en ce que le circuit imprimé (1) est disposé dans un boîtier de matière plastique (10) et la plaque métallique (11) est en contact d'une tige métallique (15) injectée dans le boîtier de matière plastique (10).

4. Dispositif selon la revendication 3, caractérisé en ce que la tige métallique (15) est portée directement à un potentiel fixe (17).

5. Dispositif selon la revendication 3, caractérisé en ce qu'entre la tige métallique (15) et le potentiel fixe (17) est disposé un second trajet d'étincelle (18).

6. Dispositif selon la revendication 1, caractérisé en ce que la piste conductrice (19) à protéger présente une amenée à une broche (6) d'une liaison par prise.

7. Dispositif selon la revendication 1, caractérisé en ce que la tension de claquage entre la piste conductrice (19) et la plaque métallique (11) est déterminée par l'épaisseur de la couche d'isolement (9).

8. Dispositif selon l'une quelconque des revendications 2, 4 ou 5, caractérisé en ce qu'il s'agit d'un potentiel de référence dans le cas du potentiel fixe.

9. Dispositif selon l'une quelconque des revendications 2, 4 ou 5, caractérisé en ce que dans le cas du potentiel fixe, il s'agit d'une tension d'alimentation d'un circuit formé des composants (2).

10. Dispositif selon l'une quelconque des revendications 2, 4 ou 5, caractérisé en ce que dans le cas du potentiel fixe, il s'agit d'un potentiel fixe quelconque du circuit.

11. Dispositif selon la revendication 1, caractérisé en ce qu'entre le circuit imprimé (1) et la couche d'isolement (9) est disposée une couche de vernis d'arrêt de soudure (12).

12. Dispositif selon la revendication 1, caractérisé en ce que les pistes conductrices (19) à travers l'ouverture (13) présentent un écartement mutuel au moins quadruple de celui à l'extérieur de l'ouverture (13).
